Europäisches Patentamt

(19) European Patent Office

Office européen des brevets

(11) Veröffentlichungsnummer: **0 027 495**
A1

(12) **EUROPÄISCHE PATENTANMELDUNG**

(21) Anmeldenummer: 80103413.3

(22) Anmeldetag: 19.06.80

(51) Int. Cl.³: **H 03 K 17/16**
F 02 P 7/06, H 02 H 3/24

(30) Priorität: 27.09.79 DE 2939107

(43) Veröffentlichungstag der Anmeldung:
29.04.81 Patentblatt 81/17

(84) Benannte Vertragsstaaten:
DE FR GB IT SE

(71) Anmelder: ROBERT BOSCH GMBH
Postfach 50
D-7000 Stuttgart 1(DE)

(72) Erfinder: Jundt, Werner
Belscherstrasse 24
D-7140 Ludwigsburg(DE)

(72) Erfinder: Roozenbeek, Herman
Breslauer Strasse 51
D-7141 Schwieberdingen(DE)

(54) Vorrichtung zum Erzeugen eines binären Ausgangssignals eines Hallgenerators.

(57) Da bei sinkender Betriebsspannung (+Uv) die Einschalt-Induktion eines Hallgenerators (1) ansteigt, wird eine Schaltungsanordnung vorgesehen, die das vom Hallgenerator (1) über eine intergrierte Schaltung gelieferte binäre Ausgangssignal dann abschaltet, wenn die Betriebsspannung (+Uv) einen vorbestimmten Schwellenwert unterschreitet. Dadurch wird insbesondere verhindert, daß bei Schwankungen der Betriebsspannung (+Uv) um einen kritischen Wert das Ausgangssignal mehrmals wechselt. Die Vorrichtung eignet sich besonders zur Verwendung bei Hallgeneratoren, die in der Zündvorrichtung eines Kraftfahrzeugs verwendet sind.

EP 0 027 495 A1

Dr. Vetter

R. 5763
20.9.1979 A 48 R-ef

<u>ROBERT BOSCH GMBH, 7000 Stuttgart 1</u>

<u>Vorrichtung zum Erzeugen eines binären Ausgangssignals
eines Hallgenerators</u>

<u>Stand der Technik</u>

Die Erfindung betrifft eine Vorrichtung gemäß der Gattung
des Hauptanspruchs. Bei bekannten derartigen Anordnungen
ist das binäre Ausgangssignal nicht nur von der Größe der
Induktion abhängig, der der Hallgenerator ausgesetzt ist,
sondern auch von der Betriebsspannung, so daß sich bei Betriebsspannungsänderungen der Zustand des Ausgangssignals
in unerwünschter Weise ändern kann. Derartige Vorrichtungen werden u.a. bei Zündvorrichtungen für Kraftfahrzeuge
verwendet, und hier kann es vorkommen, daß durch Einstreuen von Zündsignalen auf die Stromversorgungsleitung der
Vorrichtung sich die Betriebsspannung für die Vorrichtung
kurzzeitig ändert und dadurch auch das Ausgangssignal sich
ändert. Die Änderung des Ausgangssignals kann wiederum die Zündvorrichtung beeinflussen, wodurch falsche Zündsignale erzeugt werden und durch Rückwirkung dieser Zündsignale auf den Hallgenerator die Anordnung zum Schwingen kommen kann. Die Änderung des Ausgangssignals in Abhängigkeit von der Betriebsspannung hat ihre Ursache darin, daß bei sinkender Betriebsspannung auch der durch den Hallgenerator fließende Strom geringer wird, wodurch zum Erzeugen einer bestimmten Hallspannung eine größere Induktion erforderlich ist als bei größerer Betriebsspannung. Das an sich analoge Ausgangssignal des Hallgenerators wird durch eine elektronische Schaltung, die häufig als integrierte Schaltung ausgebildet ist, in das binäre Ausgangssignal umgesetzt. Bei abnehmender Betriebsspannung rücken die Kurven für die Ausschaltinduktion und die Einschaltinduktion des Hallgenerators, bei deren Überschreiten nach unten bzw. oben das binäre Aus- bzw. Ein-Signal abgegeben wird, dichter zusammen, so daß dann, wenn die Betriebsspannung auf einen kritischen Wert abgesunken ist, der von der augenblicklich herrschenden Induktion abhängt, bereits kleinere Schwankungen der Betriebsspannung dazu führen können, daß der Hallgenerator entsprechend diesen Schwankungen mehrmals ein- und ausschaltet.

## Vorteile der Erfindung

Demgegenüber hat die erfindungsgemäße Vorrichtung mit den kennzeichnenden Merkmalen des Hauptanspruchs den Vorteil, daß unerwünschte Änderungen des binären Ausgangssignals infolge Schwankungen der Betriebsspannung, insbesondere schnelle unerwünschte Änderungen des Ausgangssignals beim Pendeln der Betriebsspannung um einen kritischen Wert, vermieden sind. Der Schwellenwert der Versorgungsspannung

- 3 -

ist so gewählt, daß die Änderungen des binären Ausgangssignals ausschließlich von der Induktion, die auf den Hallgenerator wirkt, abhängig sind, solange die Betriebsspannung oberhalb des Schwellenwert liegt.

Gemäß einer Ausführungsform der Erfindung weist der bei zu
niedriger Betriebsspannung abschaltende Schalter ein Hystereseverhalten auf, er schaltet also erst bei einer merklich höheren Betriebsspannung wieder ein, als bei der das
Abschalten erfolgt. Hierdurch wird ein unerwünschtes Wechseln des Ausgangssignals bei Schwankungen der Betriebsspannung um den Schwellenwert verhindert.

Zeichnung

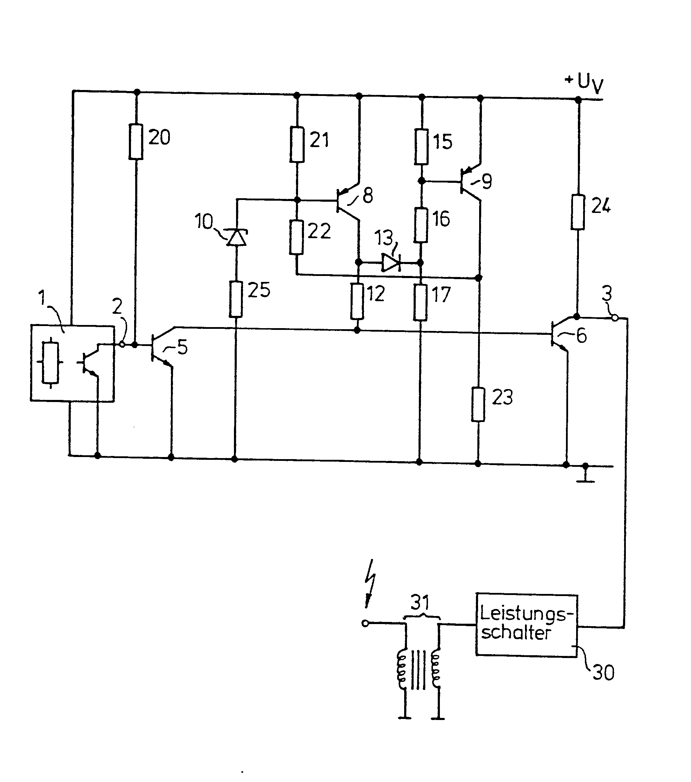

In der einzigen Figur ist ein Ausführungsbeispiel einer
erfindungsgemäßen Vorrichtung, die bei einer Zündvorrichtung eines Kraftfahrzeugs verwendet ist, anhand eines
Schaltbilds dargestellt.

Beschreibung des Ausführungsbeispiels

Ein in einem nicht dargestellten Zündverteiler eines
Kraftfahrzeugs anstatt des üblichen Unterbrecherkontakts
angeordneter schematisch angedeuteter Hallgenerator 1 mit
zugehöriger integrierter Schaltung zum Erzeugen eines
binären Ausgangssignals in Abhängigkeit von der Größe der
auf den Hallgenerator wirkenden magnetischen Induktion
ist mit der im einzelnen gezeigten Schaltungsanordnung an
deren Eingang 2 verbunden, die einen unerwünschten Wechsel des Ausgangssignals des Hallgenerators 1 infolge von
Betriebsspannungsschwankungen an ihrem Ausgang 3 nicht

- 4 -

wirksam werden läßt. Der Hallgenerator 1 mit zugehöriger integrierter Schaltung ist ebenso wie die ihm nachgeschaltete Schaltungsanordnung mit dem positiven Pol einer Betriebsspannungsquelle Uv verbunden. Das dem Eingang 2 zugeführte Signal gelangt zur Basis eines npn-Transistors 5, dessen Kollektor mit der Basis eines npn-Transistors 6 verbunden ist, dessen Kollektor den Ausgang 3 bildet. Die Schaltungsanordnung weist zwei pnp-Transistoren 8 und 9 auf, die miteinander so verbunden sind, daß sie eine bistabile Kippschaltung bilden. Eine Zenerdiode 10 sorgt dafür, daß das Basispotential des Transistors 8 annähernd auf einem konstanten Wert liegt, solange die Betriebsspannung Uv oberhalb eines vorbestimmten Schwellenwerts liegt. In diesem Fall ist der Transistor 8 ständig leitend und der Transistor 9 gesperrt. Der Kollektor des Transistors 8 ist einerseits über einen Widerstand 12 mit dem Kollektor des Transistors 5 und der Basis des Transistors 6 verbunden, andererseits mit der Anode einer Diode 13, deren Kathode mit einem Abgriff eines Spannungsteilers 15, 16, 17 verbunden ist, wobei mit einem anderen, auf einem höheren Potential liegenden Abgriff dieses Spannungsteilers die Basis des Transistors 9 verbunden ist. Die Schaltung weist weitere Widerstände 20 bis 25 auf, wie die Zeichnung zeigt. Der Ausgang 3 ist mit einem Eingang eines Leistungsschalters 30 verbunden, der die Primärwicklung eines Zündtransformators 31 speist, dessen Sekundärwicklung die Zündimpulse liefert, die in nicht dargestellter Weise über ein Zündkabel dem Zündverteiler zugeführt werden, in dem sich der Hallgenerator 1 befindet.

Es sei angenommen, daß der Hallgenerator 1 dem Eingang 2 dann ein den eingeschalteten Zustand charakterisierendes Signal mit einem niedrigen Spannungspegel zuführt, wenn die Induktion einen hohen Wert hat, und daß das dem Eingang 2 zugeführte Signal einen hohen Spannungswert hat, der den Aus-Zustand charakterisiert, wenn die Induktion ausreichend klein ist. Es wird angenommen, daß die Betriebsspannung Uv ausreichend hoch ist. Dann ist der Transistor 8 durchgeschaltet und der Transistor 9 gesperrt. Wenn am Eingang 2 ein hohes Potential anliegt, so ist das Potential des Kollektors des Transistors 5 niedrig und das des Kollektors des Transistors 6 hoch. Nimmt nun die Betriebsspannung Uv ab, so wird bei einem bestimmten Schwellenwert von Uv die Basis-Emitter-Spannung des Transistors 8 nicht mehr ausreichen, um diesen leitend zu halten. Dieser Transistor 8 sperrt also und der Transistor 9 wird leitend. Da dem Transistor 6 nun über den Widerstand 12 kein Strom mehr zugeführt werden kann, ist der Transistor 5 unwirksam, und das Ausgangssignal am Ausgang 3 ist unabhängig von Änderungen des dem Eingang 2 zugeführten Signals.

Das Hystereseverhalten der die Transistoren 8 und 9 enthaltenden stabilen Kippschaltung bewirkt, daß beim nachfolgenden Ansteigen der Betriebsspannung Uv der Transistor 8 erst wieder leitend wird, wenn die Betriebsspannung einen Wert erreicht hat, der höher liegt als der Wert, bei dem der Transistor 8 sperrt.

Es ist wichtig, daß der Schwellenwert der Betriebsspannung, bei dessen Unterschreiten der Transistor 8 sperrt, so hoch liegt, daß das Unterschreiten dieses Schwellenwerts bei allen im konkreten Fall auftretenden Größen der Induktion noch nicht das Abschalten des Hallgenerators selbst bewirkt, also nicht zur Folge hat, daß ein dem Eingang 2 zugeführtes Ein-Signal sich in ein Aus-Signal ändert.

- 6 -

Im oben beschriebenen Ausführungsbeispiel liegt der
Schwellenwert, bei dessen Unterschreiten die Schaltungsanordnung abschaltet, auch oberhalb derjenigen Spannung,
die der Hallgenerator benötigt, um bei einer vorbestimmten Induktion das Ein-Signal zu erzeugen.

R. **5**7 6 3
20.9.1979 A 48 R-ef

<u>ROBERT BOSCH GMBH, 7000 Stuttgart 1</u>

<u>Ansprüche</u>

1. Vorrichtung zum Erzeugen eines binären Ausgangssignals eines Hallgenerators, dadurch gekennzeichnet, daß eine die Versorgungsspannung (Uv) der Vorrichtung überwachende Schaltungsanordnung (5 bis 25) vorgesehen ist, die beim Unterschreiten eines vorbestimmten Schwellenwerts der Versorgungsspannung ein vom Induktionswert unabhängiges Ausgangssignal liefert.

2. Vorrichtung nach Anspruch 1, dadurch gekennzeichnet, daß die Schaltungsanordnung einen von der Betriebsspannung gesteuerten elektrischen Schalter (8, 9) mit Hystereseverhalten aufweist.

Europäisches
Patentamt

**EUROPÄISCHER RECHERCHENBERICHT**

Nummer der Anmeldung

EP 80 10 3413.3

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - B2 - 2 350 362 (SIEMENS AG) | 1 |
| | * Spalte 3, Zeilen 3 bis 13; Fig. * | |
| | -- | |
| | CH - A - 539 349 (ELIN-UNION-AKTIENGE-SELLSCHAFT FÜR ELEKTRISCHE INDUSTRIE) | 1 |
| | * Patentanspruch * | |
| | -- | |
| | DE - A1 - 2 415 629 (LICENTIA PATENT-VERWALTUNGS-GMBH) | 1 |
| | * Anspruch 1 * | |
| | -- | |
| A | US - A - 3 875 920 (M. WILLIAMS) | 1 |
| | ---- | |

**KLASSIFIKATION DER ANMELDUNG (Int. Cl.³)**

H 03 K 17/16
F 02 P 7/06
H 02 H 3/24

**RECHERCHIERTE SACHGEBIETE (Int. Cl³)**

F 02 P 7/06
H 02 H 3/24
H 03 K 5/01
H 03 K 17/16
H 03 K 17/30
H 03 K 17/90

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| Berlin | 20-01-1981 | ARENDT |

EPA form 1503.1 06.78